# EUROPEAN PATENT APPLICATION

(11) **EP 4 628 254 A1**
(43) Date of publication of application: **08.10.2025**
(21) Application number: 23897356.4
(22) Date of filing: 01.11.2023
(51) Int. Cl.: B24B 9/00, B24B 21/00, B24B 49/02, H01L 21/304

(54) **POLISHING INFORMATION PROCESSING DEVICE, PREDICTION DEVICE, AND MACHINE LEARNING DEVICE**

(30) Priority: 28.11.2022 JP 2022188873
(71) Applicant: EBARA CORPORATION, Ota-ku, Tokyo 144-8510 (JP)
(72) Inventor: Midorikawa, Shugo, Tokyo 144-8510 (JP)
(74) Representative: Carstens, Dirk Wilhelm
(86) International application number: PCT/JP2023/039383
(87) International publication number: WO 2024/116700

(57) **Abstract**

The present invention relates to a polishing-information processing apparatus provided in a polishing apparatus for polishing a peripheral portion of a substrate. The polishing-information processing apparatus (112) includes an information acquisition part (241) for acquiring polishing conditions and profiles of a peripheral portion of a wafer (W) before and after polishing; a state prediction part (240b) for predicting a profile of the peripheral portion of the substrate after polishing by inputting the polishing conditions and the profile of the peripheral portion of the substrate before polishing, which are newly acquired, into a learned model; and a correction part (242) for correcting the predicted profile of the peripheral portion of the substrate after polishing based on the profile of the peripheral portion of the substrate after polishing, which is predicted by the state prediction part (240b) and a target profile.

## Description

### Technical Field

The present invention relates to a polishing-information processing apparatus provided in a polishing apparatus for polishing a substrate, such as a wafer, and in particular relates to a polishing-information processing apparatus provided in a polishing apparatus for polishing a peripheral portion of a substrate. Further, the present invention relates to a prediction apparatus for predicting a profile of the peripheral portion of the substrate after polishing, and a prediction apparatus for predicting polishing conditions used in the polishing apparatus. Furthermore, the present invention relates to a machine learning apparatus for constructing a learned model for predicting the profile of the peripheral portion of the substrate after polishing, and a machine learning apparatus for constructing a learned model for predicting the polishing conditions used in the polishing apparatus.

### Background Art

Management of a surface condition of a substrate, such as a wafer, has recently attracted attention from the viewpoint of an increase in a yield in manufacturing of semiconductor devices. In a semiconductor device manufacturing process, films of various materials are formed on a silicon wafer. Therefore, an unnecessary film or surface roughness may be formed on a peripheral portion of the substrate. These days it is a common practice to transport a substrate by holding only the peripheral portion of the substrate with arms. With such a background, an unnecessary film, remaining on the peripheral portion of the substrate, may peel off during various processes and may adhere to devices formed on the substrate, resulting in reduced a yield.

Thus, in order to remove the unnecessary film from the peripheral portion of the substrate, a polishing apparatus is used to polish the peripheral portion of the substrate (See Patent document 1, for example). Additionally, with laminating of substrates to improve integration density in recent years, controlling a cross-sectional shape of the peripheral portion upon thinning is an important factor in preventing substrate cracking and improving yield.

### Citation List

### Patent Literature

Patent document 1: Japanese Patent No. 6614978

### Summary of Invention

### Technical Problem

Conventionally, in order to create most suitable polishing conditions (polishing recipe) to obtain an optimal profile (surface profile) of the peripheral portion of the substrate after polishing, the profile of the peripheral portion of the substrate before polishing is measured, and then operator creates polishing conditions based on the obtained profile before polishing. In order to determine the polishing conditions, the operator needs specialized knowledge and it takes time to find appropriate polishing conditions.

According to the polishing method described in Patent document 1, the appropriate polishing conditions can be obtained in a relatively short time. However, with this method, the substrate can only be polished using polishing conditions selected from a plurality of polishing conditions that have been prepared in advance for each type of substrate peripheral portion. In an actual polishing process, it is necessary to determine appropriate polishing conditions according to various profiles of the peripheral portion of the substrate, and to polish the peripheral portion of the substrate. Further, even substrates having the same profile need to be polished into various profiles according to a manufacturing process after polishing and/or an application of the substrate. Therefore, there is a need for a technology that enables the optimal polishing conditions to be determined in order to obtain the desired profile after polishing, even if the substrate has various profiles before polishing.

Therefore, the present invention provides a polishing-information processing apparatus capable of automatically and accurately determining appropriate polishing conditions for obtaining a desired profile of a peripheral portion of a substrate after polishing.

Further, the present invention provides a prediction apparatus for predicting a profile of a peripheral portion of a substrate after polishing, in order to obtain a desired profile of the peripheral portion of the substrate after polishing.

Furthermore, the present invention provides a prediction apparatus for predicting polishing conditions for obtaining a desired profile of a peripheral portion of a substrate after polishing.

In addition, the present invention provides a machine learning apparatus for constructing a learned model for obtaining a desired profile of a peripheral portion of a substrate after polishing.

### Solution to Problem

In one embodiment, there is provided a polishing-information processing apparatus for a polishing apparatus which polishes a peripheral portion of a substrate by pressing a polishing tool against the peripheral portion of the substrate with a polishing head in a presence of a polishing liquid while rotating the substrate held on a holding stage, comprising: an information acquisition part configured to acquire polishing conditions for polishing the peripheral portion of the substrate, a profile of the peripheral portion of the substrate before polishing, and a profile of the peripheral portion of the substrate after polishing under the polishing conditions; a state prediction part configured to predict the profile of the peripheral portion of the substrate after polishing by inputting information including at least the polishing conditions and the profile of the peripheral portion of the substrate before polishing, which are newly acquired by the information acquisition part, into a learned model constructed using a learning data set which includes at least a combination of the polishing conditions and the profiles before and after polishing acquired in advance by the information acquisition part; and a correction part configured to correct the newly acquired polishing conditions based on the profile of the peripheral portion of the substrate after polishing predicted by the state prediction part and the target profile of the peripheral portion of the substrate.

In one embodiment, the polishing conditions include holding-stage conditions representing a state of the holding stage; and the holding-stage conditions include at least one of the number of rotations of the holding stage from start of polishing to end of polishing of the substrate, a rotational speed of the holding stage, a rotational acceleration of the holding stage, and a rotation time of the holding stage from start of polishing to end of polishing of the substrate.

In one embodiment, the polishing apparatus further comprises a tilt mechanism capable of tilting the polishing head with respect to the peripheral portion of the substrate; the polishing conditions include polishing-head conditions representing a state of the polishing head; and the polishing-head conditions include at least one of a pressing force with which the polishing head presses the polishing tool against the substrate, a tilt angle range of the polishing head with respect to the peripheral portion of the substrate, a polishing time during which the polishing head presses the polishing tool against the substrate, a tilt movement speed at which the polishing head moves relative to the peripheral portion of the substrate, and a tilt fixing time which is used for temporarily stopping the movement of the polishing head at a predetermined tilt angle.

In one embodiment, the polishing tool comprises a polishing tape; the polishing apparatus further comprises a polishing-tape supply device configured to supply the polishing tape to the polishing head while applying tension to the polishing tape; and the polishing-head conditions further include the tension of the polishing tape and/or a supply speed of the polishing tape.

In one embodiment, the polishing apparatus further comprises a polishing-liquid supply nozzle configured to supply the polishing liquid onto the substrate; the polishing conditions include polishing-liquid conditions related to the polishing liquid; and the polishing liquid conditions include at least one of a flow rate of the polishing liquid discharged from the polishing-liquid supply nozzle, a pressure of the polishing liquid, a temperature of the polishing liquid, a concentration of abrasive grains contained in the polishing liquid, and a position of the polishing-liquid supply nozzle with respect to the substrate.

In one embodiment, the peripheral portion of the substrate includes a bevel portion that is the outermost surface of the substrate, and the profile of the peripheral portion of the substrate before polishing included in the learning data set, and the profile of the peripheral portion of the substrate after polishing predicted by the learned model include at least one of: a center coordinate of a front surface arc portion of the bevel portion; a radius of a front surface arc portion of the bevel portion; a center coordinate of a back surface arc portion of the bevel portion; and a radius of a back surface arc portion of the bevel portion.

In one embodiment, the peripheral portion of the substrate includes a bevel portion which is the outermost surface of the substrate, and a top edge portion which is a flat portion located radially inwardly of the bevel portion, and the profile of the peripheral portion of the substrate after polishing included in the learning data set, and the profile of the peripheral portion of the substrate after polishing predicted by the learned model include a polishing width of the top edge portion and/or a polishing depth of the top edge portion.

In one embodiment, there is provided a prediction apparatus for predicting a profile of a peripheral portion of a substrate polished by a polishing apparatus configured to polish the peripheral portion of the substrate by pressing a polishing tool against the peripheral portion of the substrate with a polishing head in a presence of a polishing liquid while rotating the substrate held on a holding stage, comprising a processor configured to perform: an information acquisition process for acquiring information including at least polishing conditions for polishing the peripheral portion of the substrate, a profile of the peripheral portion of the substrate before polishing, and a profile of the peripheral portion of the substrate after polishing under the polishing conditions; and a prediction process of inputting polishing conditions and a profile of the peripheral portion of the substrate before polishing which are newly acquired by the information acquisition process, into a learned model which is constructed using a learning data set including information acquired in advance by the information acquisition process, to thereby predict a profile of the peripheral portion of the substrate after polishing.

In one embodiment, there is provided a machine learning apparatus for constructing a learned model that outputs a profile of a peripheral portion of a substrate after a polishing process in which a polishing tool is pressed against the peripheral portion of the substrate with a polishing head in a presence of a polishing liquid while rotating the substrate held on a holding stage, comprising: a learning data storage part configured to store a learning data set constructed by a plurality of pieces of information containing a combination of polishing conditions for polishing the peripheral portion of the substrate, a profile of the peripheral portion of the substrate before polishing, and a profile of the peripheral portion of the substrate after polishing under the polishing conditions; a machine learning part configured to construct the learned model for predicting the profile of the peripheral portion of the substrate after polishing by inputting the learning data set into the learning model; and a learned model storage part configured to store the learned model constructed by the machine learning part.

In one embodiment, there is provided a polishing-information processing apparatus for a polishing apparatus which polishes a peripheral portion of a substrate by pressing a polishing tool against the peripheral portion of the substrate with a polishing head in a presence of a polishing liquid while rotating the substrate held on a holding stage, comprising: an information acquisition part configured to acquire polishing conditions for polishing the peripheral portion of the substrate, a profile of the peripheral portion of the substrate before polishing, and a profile of the peripheral portion of the substrate after polishing under the polishing conditions; and a state prediction part configured to predict new polishing conditions for bringing the profile of the peripheral portion of the substrate after polishing closer to the target profile by inputting information including at least the polishing conditions and the profile of the peripheral portion of the substrate before polishing, which are newly acquired by the information acquisition part, and a target profile, into a learned model constructed using a learning data set which includes at least a combination of the polishing conditions and the profiles before and after polishing acquired in advance by the information acquisition part.

In one embodiment, there is provided a prediction apparatus for predicting polishing conditions used in a polishing apparatus configured to polish the peripheral portion of the substrate by pressing a polishing tool against the peripheral portion of the substrate with a polishing head in a presence of a polishing liquid while rotating the substrate held on a holding stage, comprising a processor configured to perform: an information acquisition process for acquiring information including at least polishing conditions for polishing the peripheral portion of the substrate, a profile of the peripheral portion of the substrate before polishing, and a profile of the peripheral portion of the substrate after polishing under the polishing conditions; and a prediction process of inputting polishing conditions, a profile of the peripheral portion of the substrate before polishing, and a target profile which are newly acquired by the information acquisition process, into a learned model which is constructed using a learning data set including information acquired in advance by the information acquisition process, to thereby predict new polishing conditions for bringing the profile of the peripheral portion of the substrate after polishing closer to the target profile.

In one embodiment, there is provided a machine learning apparatus for constructing a learned model that outputs polishing conditions for polishing process in which a polishing tool is pressed against a peripheral portion of a substrate with a polishing head in a presence of a polishing liquid while rotating the substrate held on a holding stage, comprising: a learning data storage part configured to store a learning data set constructed by a plurality of pieces of information containing a combination of polishing conditions for polishing the peripheral portion of the substrate, a profile of the peripheral portion of the substrate before polishing, and a profile of the peripheral portion of the substrate after polishing under the polishing conditions; a machine learning part configured to construct a learned model for outputting new polishing conditions for bringing the profile of the peripheral portion of the substrate after polishing closer to the target profile by inputting the learning data set into the learning model; and a learning model storage part configured to store the learned model constructed by the machine learning part.

### Advantageous Effects of Invention

The polishing conditions are corrected based on the profile of the peripheral portion of the wafer W after polishing, which is predicted by the learned model, and the target profile of the peripheral portion of the wafer W. Alternatively, the optimal polishing conditions for bringing the profile of the peripheral portion of the wafer W after polishing closer to the target profile of the peripheral portion of the wafer W are predicted by the learned model. As a result, appropriate polishing conditions can be produced automatically and accurately.

### Brief Description of Drawings

[FIG. 1] FIG. 1 is a plan view showing an overall configuration of a polishing apparatus according to one embodiment;
[FIG. 2A] FIG. 2A is a cross-sectional view of a straight-type wafer;
[FIG. 2B] FIG. 2B is a cross-sectional view of a so-called round-type wafer;
[FIG. 3] FIG. 3 is a plan view showing a polishing module according to an embodiment;
[FIG. 4] FIG. 4 is a longitudinal sectional view of the polishing module shown in FIG. 3;
[FIG. 5] FIG. 5 is an enlarged view of the polishing head;
[FIG. 6] FIG. 6 is a view showing a manner in which the polishing head polishes a bevel portion of the wafer;
[FIG. 7] FIG. 7 is a view showing a state in which the polishing head polishes a top edge portion of the wafer;
[FIG. 8] FIG. 8 is a view showing a state in which the polishing head polishes a bottom edge portion of the wafer;
[FIG. 9] FIG. 9 is a schematic view showing a polishing-information processing apparatus according to one embodiment;
[FIG. 10] FIG. 10 is a schematic view for illustrating a center coordinate of a front surface arc portion of the bevel portion, a radius of the front surface arc portion, a center coordinate of a back surface arc portion, and a radius of the back surface arc portion of the bevel;
[FIG. 11] FIG. 11 is a schematic view for illustrating a stepped recess formed in the peripheral portion of the wafer W by the polishing process
[FIG. 12] FIG. 12 is a schematic view showing a structure of neural network according to one embodiment; and
[FIG. 13] FIG. 13 is a schematic view showing a structure of neural network according to another embodiment.

### Description of Embodiments

Embodiments according to the present invention will be described below with reference to the drawings.

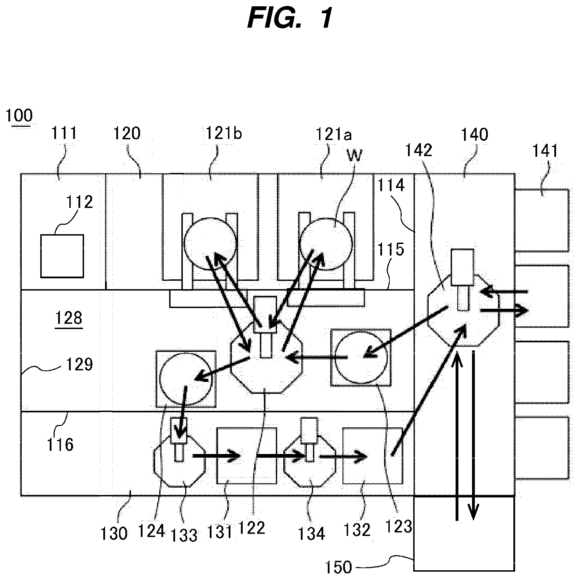

FIG. 1 is a plan view showing an overall configuration of a polishing apparatus according to one embodiment. The arrows in FIG. 1 indicate transport directions of a wafer W, which is an example of a substrate. The polishing apparatus shown in FIG. 1 is an apparatus for polishing a peripheral portion of the wafer W.

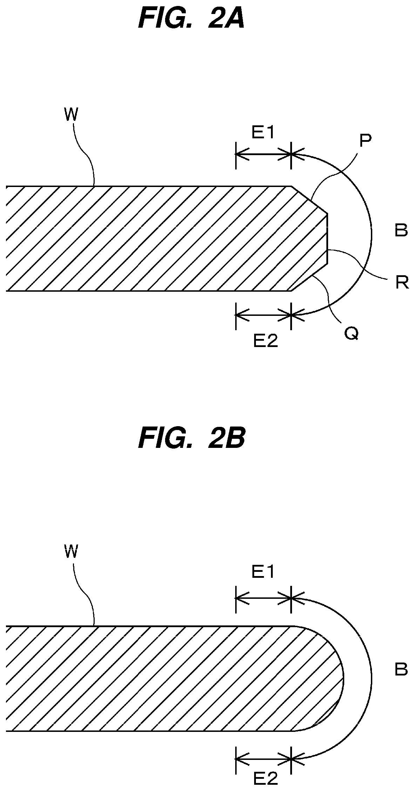

FIG. 2A and FIG. 2B are enlarged cross-sectional views each showing a peripheral portion of a wafer. More specifically, FIG. 2A is a cross-sectional view of a so-called straight-type wafer, and FIG. 2B is a cross-sectional view of a so-called round-type wafer. In the wafer W shown in FIG. 2A, a bevel portion is an outermost circumferential surface of the wafer W (indicated by a letter B) that is constituted by an upper slope portion (an upper bevel portion) P, a lower slope portion (a lower bevel portion) Q, and a side portion (an apex) R.

In the wafer W shown in FIG. 2B, the bevel portion is a portion (indicated by a letter B) having a curved cross section and forming an outermost circumferential surface of the wafer W. A top edge portion E1 is a flat portion located radially inwardly of the bevel portion B and located radially outwardly of a region D where devices are formed. A bottom edge portion E2 is a flat portion located radially inwardly of the bevel portion B and located at an opposite side from the top edge portion E1. The top edge portion E1 and the bottom edge portion E2 may be collectively referred to as a near edge portion.

Returning to FIG. 1, the polishing apparatus 100 has a substantially rectangular housing. An interior of the housing is partitioned into a polishing unit 120, a cleaning unit 130, and a loading/unloading portion 140 by partition walls 114, 115, 116. The polishing unit 120, the cleaning unit 130, and the loading/unloading unit 140 are independently assembled and independently evacuated. Further, the polishing apparatus 100 is provided with a controller 111 for controlling operations of the polishing unit 120, the cleaning unit 130, and the load/unload unit 140.

Furthermore, the polishing apparatus 100 includes a shape measuring device (profiler) 150 for acquiring a profile (surface shape) of the peripheral portion of the wafer W. The type and configuration of the shape measuring device 150 are freely selected as long as it is possible to acquire the profile of the peripheral portion of the wafer W. For example, the shape measuring device 150 may be a non-contact type shape measuring device configured to acquire the profile of the peripheral portion of the wafer W using at least one camera, or at least one infrared emitter or laser emitter, or may be a contact type shape measuring device configured to acquire the profile of the peripheral portion of the wafer W by scanning a contact probe across the surface of the wafer W.

As shown in FIG. 1, the load/unload unit 140 has a plurality (four in the illustrated example) of front loading portions 141 arranged adjacent to each other in a front side of the load/unload unit 140, and a first transfer robot 142 movable in an arrangement direction of the front loading portions 141.

Wafer cassette for storing the plurality of wafers W is placed on the front load portion 141. Specifically, the front loading portion 141 may be placed with, for example, an open cassette, an SMIF (Standard Manufacturing Interface) pod, or a FOUP (Front Opening Unified Pod). SMIF and FOUP are closed containers that accommodate wafer cassettes and are covered with partition walls to maintain an environment independent of the external space.

The first transfer robot 142 moves along the arrangement direction of the front loading portions 141, and is thus capable of accessing the wafer cassettes loaded on each front loading portion 141. This first transfer robot 142 has two hands (not shown) located above and below, and is, for example, configured to use the upper hand when returning the wafer W to the wafer cassette and to use the lower hand when transferring the wafer W before polishing, so that the upper and lower hands can be used separately.

The polishing unit 120 shown in FIG. 1 corresponds to an area where polishing of the wafer W is performed, and includes at least one (two in the illustrated example) polishing modules 121a and 121b, a first temporary table 123 where the wafer W before polishing is temporarily placed, a second temporary table 124 where the wafer W after polishing is temporarily placed, and a second transfer robot 122 for transferring the wafer W between the polishing modules 121a, 121b, the first temporary table 123, and the second temporary table 124. In the present embodiment, the polishing modules 121a and 121b are polishing modules, respectively, which polish the peripheral portion of the substrate by sliding a polishing tool in contact with the peripheral portion of the substrate in a presence of a liquid, such as pure water and a chemical liquid.

The cleaning unit 130 corresponds to an area for cleaning and further drying the wafer W after polishing, and includes a cleaning module 131, a drying module 132, a third transfer robot 133, and a fourth transfer robot 134.

The third transfer robot 133 is disposed between the second temporary table 124 of the polishing unit 120 and the cleaning module 131, and transfers the wafer W after polishing from the second temporary table 124 to the cleaning module 131. The fourth transfer robot 134 is disposed between the cleaning module 131 and the drying module 132, and transfers the wafer W after cleaning from the cleaning module 131 to the drying module 132.

As the cleaning module 131, for example, a roll-sponge type cleaning module, which rotates and presses roll-shaped sponges arranged above and below against an upper surface and a lower surface of the wafer W to clean the upper surface and the lower surface of the wafer W, or a pencil-type cleaning module, which presses a hemispherical sponge against the wafer W while rotating the hemispherical sponge to clean the wafer W, can be used. As the drying module 132, for example, a spin-dry type drying module may be used, which has a stage capable of high-speed rotation of the wafer W chucked thereon, and dries the wafer W after cleaning by rotating the wafer W at high speed.

As shown in FIG. 1, the partition wall 114 serves as a partition wall that partitions the polishing unit 120 and the cleaning unit 130 from the load/unload unit 140. A transfer area 128, in which the second transfer robot 122 is disposed, is formed between the partition wall 115 that partitions the polishing unit 120 and the partition wall 116 that partitions the cleaning unit 130. The wafer W, which has been polished by the polishing modules 121a and 121b of the polishing unit 120, is transferred through the transfer area 128 to the cleaning module 131 of the cleaning unit 130.

Next, the polishing module 121a will be described below. In this embodiment, the polishing module 121b has the same configuration as the polishing module 121a, and thus, duplicate descriptions thereof are omitted.

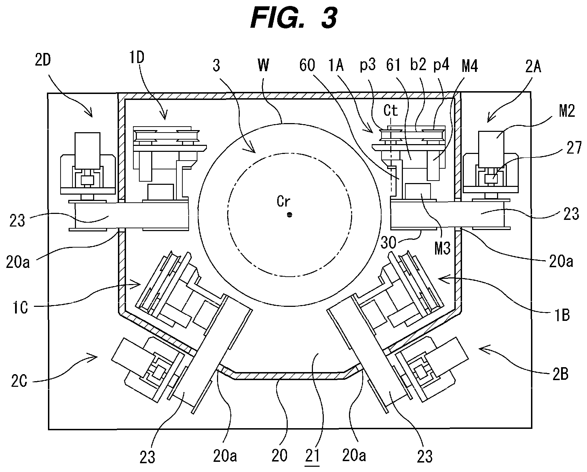

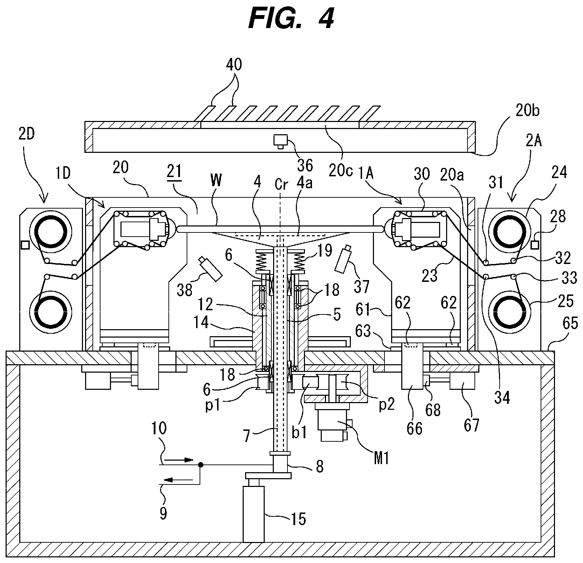

FIG. 3 is a plan view showing the polishing module 121a according to an embodiment, and FIG. 4 is a longitudinal sectional view of the polishing module 121a shown in FIG. 3. As shown in FIG. 3 and FIG. 4, this polishing module 121a includes a rotary holding mechanism (substrate holder) 3 configured to hold the wafer W horizontally and to rotate the wafer W. The rotary holding mechanism 3 is located in the center of the polishing module. FIG. 3 illustrates a state in which the rotary holding mechanism 3 holds the wafer W. The rotary holding mechanism 3 has a dish-shaped holding stage 4 configured to hold a back surface of the wafer W by use of a vacuum suction, a hollow shaft 5 coupled to a central portion of the holding stage 4, and a motor M1 for rotating the hollow shaft 5. The wafer W is placed onto the holding stage 4 by hands of a transporting mechanism (not shown) such that a center of the wafer W is aligned with a central axis of the hollow shaft 5.

The hollow shaft 5 is supported by ball spline bearings (i.e., linear motion bearings) 6 which allow the hollow shaft 5 to move vertically. The holding stage 4 has an upper surface having grooves 4a. These grooves 4a communicate with a communication line 7 extending through the hollow shaft 5. In one embodiment, a sheet having the grooves 4a which communicate with the communication line 7 extending through the hollow shaft 5 may be attached to an upper surface of the holding stage 4. The grooves 4a may be formed by punching the sheet, for example. The communication line 7 is coupled to a vacuum line 9 via a rotary joint 8 provided on a lower end of the hollow shaft 5. The communication line 7 is also coupled to a nitrogen-gas supply line 10 for use in releasing the wafer W from the holding stage 4 after processing. By selectively coupling the vacuum line 9 and the nitrogen-gas supply line 10 to the communication line 7, the wafer W can be held on the upper surface of the holding stage 4 by the vacuum suction and can be released from the upper surface of the holding stage 4.

A pulley p1 is coupled to the hollow shaft 5, and a pulley p2 is mounted on a rotational shaft of the motor M1. The hollow shaft 5 is rotated by the motor M1 through the pulley p1, the pulley p2, and a belt b1 riding on these pulleys p1 and p2. The rotational shaft of the motor M1 extends parallel to the hollow shaft 5. With these structures, the wafer W, held on the upper surface of the holding stage 4, is rotated by the motor M1.

The ball spline bearing 6 is a bearing that allows the hollow shaft 5 to move freely in its longitudinal direction. The ball spline bearings 6 are secured to a cylindrical casing 12. Therefore, in the present embodiment, the hollow shaft 5 can move linearly up and down relative to the casing 12, and the hollow shaft 5 and the casing 12 rotate in unison. The hollow shaft 5 is coupled to an air cylinder (elevating mechanism) 15, so that the hollow shaft 5 and the holding stage 4 are elevated and lowered by the air cylinder 15.

A cylindrical casing 14 is provided so as to surround the casing 12 in a coaxial arrangement. Radial bearings 18 are provided between the casing 12 and the cylindrical casing 14, so that the casing 12 is rotatably supported by the radial bearings 18. With these structures, the rotary holding mechanism 3 can rotate the wafer W about its central axis Cr, and can elevate and lower the wafer W along the central axis Cr.

As shown in FIG. 3, four polishing head assemblies (polishing portions) 1A, 1B, 1C, and 1D are arranged around the wafer W held by the rotary holding mechanism 3. Polishing-tape supply mechanisms 2A, 2B, 2C, and 2D are provided radially outwardly of the polishing head assemblies 1A, 1B, 1C, and 1D, respectively. The polishing head assemblies 1A, 1B, 1C, and 1D are isolated from the polishing-tape supply mechanisms 2A, 2B, 2C, and 2D by a partition 20. An interior space of the partition 20 provides a polishing room 21. The four polishing head assemblies 1A, 1B, 1C, and 1D and the holding stage 4 are located in the polishing room 21. On the other hand, the polishing-tape supply mechanisms 2A, 2B, 2C, and 2D are located outside the partition 20 (i.e., outside the polishing room 21). The polishing head assemblies 1A, 1B, 1C, and 1D have the same structure, and the polishing-tape supply mechanisms 2A, 2B, 2C, and 2D also have the same structure. Hereinafter, the polishing head assembly 1A and the polishing-tape supply mechanism 2A will be described.

The polishing-tape supply mechanism 2A has a supply reel 24 for supplying a polishing tape 23 as an example of a polishing tool to the polishing head assembly 1A, and a recovery reel 25 for recovering the polishing tape 23 that has been used in polishing of the wafer W. The supply reel 24 is arranged above the recovery reel 25, Motors M2 are coupled to the supply reel 24 and the recovery reel 25, respectively, via couplings 27 (FIG. 1 shows only the coupling 27 and the motor M2 coupled to the supply reel 24). Each of the motors M2 is configured to exert a constant torque in a predetermined rotational direction so as to apply a predetermined tension to the polishing tape 23.

The polishing tape 23 is a long strip-shaped polishing tool, and one of surfaces of the polishing tape 23 provides a polishing surface. The polishing tape 23 includes a base tape made from PET sheet or the like, and a polishing layer formed on the base tape. The polishing layer comprises a binder (e.g., resin) covering one surface of the base tape, and abrasive grains bound by the binder. A surface of the polishing layer provides the polishing surface. Instead of the polishing tape 23, a strip-shaped polishing cloth may be used as the polishing tool.

The polishing tape 23 is mounted on the polishing-tape supply mechanism 2A in a state where the polishing tape 23 is wound on the supply reel 24. Side surfaces of the wound polishing tape 23 are supported by reel plates so that the wound polishing tape 23 does not collapse. One end of the polishing tape 23 is attached to the recovery reel 25. The recovery reel 25 takes up the polishing tape 23 that has been supplied to the polishing head assembly 1A to thereby recover the polishing tape 23. The polishing head assembly 1A has a polishing head 30 for pressing the polishing tape 23, supplied from the polishing-tape supply mechanism 2A, against a peripheral portion of the wafer W. The polishing tape 23 is supplied to the polishing head 30 such that the polishing surface (front surface) of the polishing tape 23 faces the wafer W.

The polishing-tape supply mechanism 2A has plural guide rollers 31, 32, 33, and 34. The polishing tape 23, to be supplied to and recovered from the polishing head assembly 1A, is guided by these guide rollers 31, 32, 33, and 34. The polishing tape 23 is supplied to the polishing head 30 from the supply reel 24 through an opening 20a formed in the partition 20, and the polishing tape 23 that has been used is recovered by the recovery reel 25 through the opening 20a.

As shown in FIG. 4, an upper supply nozzle (upper polishing-liquid supply nozzle) 36 is provided above the wafer W. This upper supply nozzle 36 is configured to supply a polishing liquid onto a center of an upper surface of the wafer W held by the rotary holding mechanism 3. Further, a lower supply nozzle (lower polishing-liquid supply nozzle) 37 is provided for supplying a polishing liquid onto a boundary between the rear surface of the wafer W and the holding stage 4 of the rotary holding mechanism 3 (i.e., onto a peripheral portion of the holding stage 4). Typically, pure water is used as the polishing liquid. In a case of using silica as the abrasive grains of the polishing tape 23, ammonia may be used as the polishing liquid. The polishing apparatus further includes a cleaning nozzle 38 for cleaning the polishing head 30 after the polishing process. The wafer W is elevated by the rotary holding mechanism 3 after the polishing process, and then the cleaning nozzle 38 ejects cleaning water toward the polishing head 30, whereby the polishing head 30 is cleaned after the polishing process.

In order to isolate mechanical devices, such as the ball spline bearings 6 and the radial bearings 18, from the polishing room 21 when the hollow shaft 5 is elevated and lowered relative to the casing 12, the hollow shaft 5 and an upper end of the casing 12 are coupled to each other by a bellows 19 that is extensible and contractible in a vertical direction, as shown in FIG. 4. FIG. 4 illustrates a state in which the hollow shaft 5 is in a lowered position and the holding stage 4 is in a polishing position. After the polishing process, the air cylinder 15 elevates the wafer W, together with the holding stage 4 and the hollow shaft 5, to a transfer position, where the wafer W is released from the holding stage 4.

The partition 20 has an entrance 20b through which the wafer W is transferred into and removed from the polishing room 21. The entrance 20b is a horizontally extending cutout. Therefore, the wafer W, held by the transferring mechanism, can travel horizontally across the polishing room 21 through the entrance 20b. An upper surface of the partition 20 has an aperture 20c and louvers 40, and a lower surface of the partition 20 has a gas-discharge opening (not shown in the drawing). During the polishing process, the entrance 20b is closed by a non-illustrated shutter. Therefore, as a fan mechanism (not shown in the drawing) is driven to evacuate an air through the gas-discharge opening, downward flow of clean air is formed in the polishing room 21. Because the polishing process is performed under such conditions, the polishing liquid is prevented from scattering upwardly. Therefore, the polishing process can be performed while an upper space of the polishing room 21 is kept clean.

As shown in FIG. 1, the polishing head 30 is secured to one end of an arm 60, which is rotatable about an axis Ct extending parallel to a tangential direction of the wafer W. The other end of the arm 60 is coupled to a motor M4 via pulleys p3 and p4 and a belt b2. As the motor M4 rotates in a clockwise direction and a counterclockwise direction through a certain angle, the arm 60 rotates about the axis Ct through a certain angle. In the present embodiment, the motor M4, the arm 60, the pulleys p3 and p4, and the belt b2 constitute a tilting mechanism for tilting the polishing head 30 with respect to the surface of the wafer W.

The tilting mechanism is mounted on a movable base 61. This movable base 61 is movably coupled to a base plate 65 via guides 62 and rails 63. The rails 63 extend linearly in a radial direction of the wafer W held on the rotary holding mechanism 3, so that the movable base 61 can move linearly in the radial direction of the wafer W. A connection plate 66, extending through the base plate 65, is secured to the movable base 61. A linear actuator 67 is coupled to the connection plate 66 via a joint 68. This linear actuator 67 is secured to the base plate 65 directly or indirectly.

The linear actuator 67 may comprise an air cylinder or a combination of a positioning motor and a ball screw. The linear actuator 67, the rails 63, and the guides 62 constitute a moving mechanism for linearly moving the polishing head 30 in the radial direction of the wafer W. Specifically, the moving mechanism is operable to move the polishing head 30 closer to and away from the wafer W along the rails 63. On the other hand, the polishing-tape supply mechanism 2A is fixed to the base plate 65.

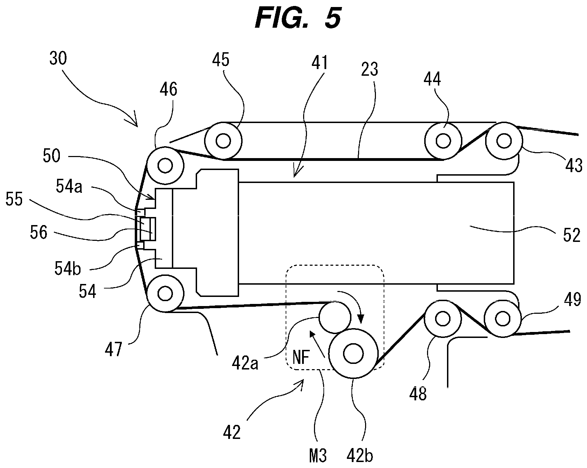

FIG. 5 is an enlarged view of the polishing head 30. As shown in FIG. 5, the polishing head 30 has a pressing mechanism 41 configured to press the polishing surface of the polishing tape 23 against the wafer W at predetermined force. The polishing head 30 further has a tape feed mechanism 42 configured to feed the polishing tape 23 from the supply reel 24 to the recovery reel 25. The polishing head 30 has plural guide rollers 43, 44, 45, 46, 47, 48, and 49, which guide the polishing tape 23 such that the polishing tape 23 travels in a direction perpendicular to the tangential direction of the wafer W.

The tape feed mechanism 42 provided in the polishing head 30 includes a tape feed roller 42a, a tape-holding roller 42b, and a motor M3 configured to rotate the tape feed roller 42a. The motor M3 is mounted on a side surface of the polishing head 30. The tape feed roller 42a is mounted to a rotational shaft of the motor M3. The tape-holding roller 42b is arranged adjacent to the tape feed roller 42a. The tape-holding roller 42b is supported by a non-illustrated mechanism, which biases the tape-holding roller 42b in a direction indicated by arrow NF in FIG. 5 (i.e., in a direction toward the tape feed roller 42a) so as to press the tape-holding roller 42b against the tape feed roller 42a.

As the motor M3 rotates in a direction indicated by arrow in FIG. 5, the tape feed roller 42a is rotated to feed the polishing tape 23 from the supply reel 24 to the recovery reel 25 via the polishing head 30. The tape-holding roller 42b is configured to be rotatable freely about its own axis and is rotated as the polishing tape 23 is fed.

The pressing mechanism 41 includes a pressing pad 50 located at the rear side of the polishing tape 23, and an air cylinder (an actuator) 52 configured to move the pressing pad 50 toward the peripheral portion of the wafer W. The air cylinder 52 is a so-called single rod cylinder. The force of the pressing pad 50 that presses the polishing tape 23 against the wafer W is regulated by controlling air pressure supplied to the air cylinder 52. The four polishing head assemblies 1A, 1B, 1C, and 1D arranged around the wafer W have the tilting mechanisms, the pressing mechanisms 41, the tape feed mechanisms 42, and the polishing-head moving mechanisms for moving each polishing head assembly, which are capable of operating independently.

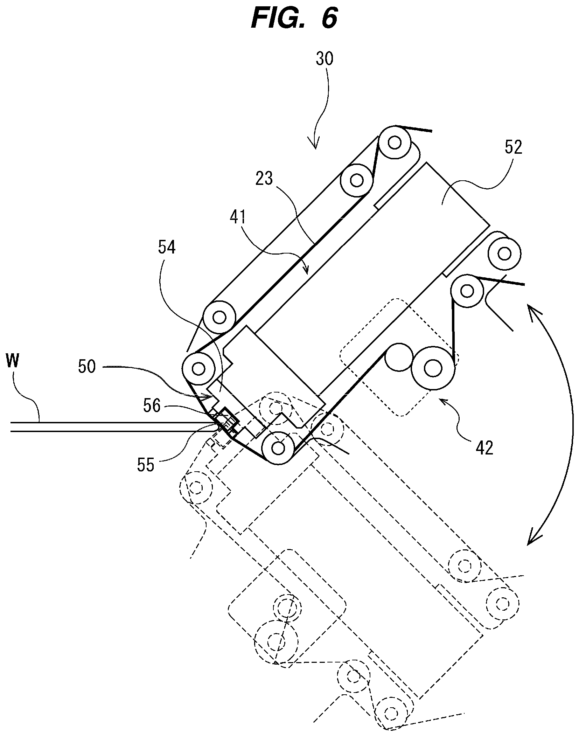

FIG. 6 is a view showing a manner in which the polishing head 30 polishes the bevel portion of the wafer W. When polishing the bevel portion of the wafer W, as shown in FIG. 6, the polishing tape 23 is pressed against the bevel portion of the water W by the pressing pad 50 while the inclination angle of the polishing head 30 is changed intermittently or continuously by the above-described tilting mechanism. During polishing, the polishing tape 23 may be fed at a predetermined speed by the tape feed mechanisms 42.

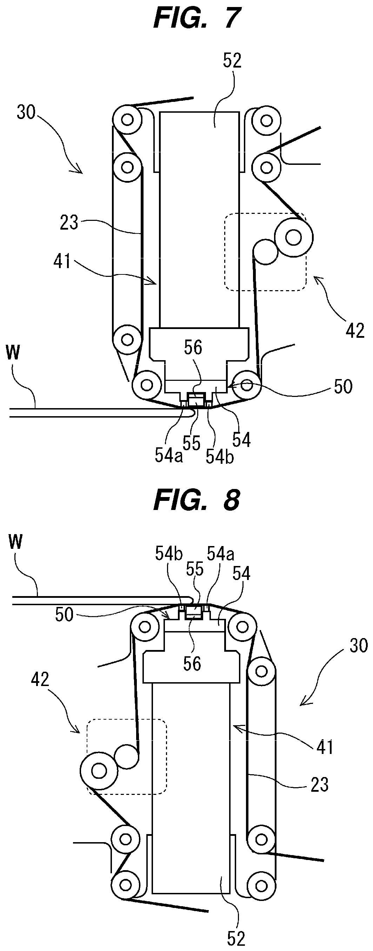

Further, the polishing head 30 having the pressing pad 50 according to the present embodiment is capable of polishing the top edge portion and the bottom edge portion of the wafer W. Specifically, as shown in FIG. 7, the polishing head 30 is inclined upward by the above-described tilting mechanism to allow the protrusion 54a to press the polishing tape 23 against the top edge portion of the wafer W, thereby polishing the top edge portion of the wafer W. Further, as shown in FIG. 8, the polishing head 30 is inclined downward to allow the protrusion 54b to press the polishing tape 23 against the bottom edge portion of the wafer W, thereby polishing the bottom edge portion of the wafer W.

As described above, the polishing head 30 according to the present embodiment can polish the entire peripheral portion of the wafer W including the top edge portion E1, the bevel portion B and the bottom edge portion E2. Each of the polishing head assemblies 1A to 1D (see FIG. 3) has the polishing head 30. Therefore, in order to improve a throughput of the polishing apparatus, all of the polishing head assemblies 1A to 1D may polish the entire peripheral portion of the wafer W including the top edge portion E1, the bevel portion B and the bottom edge portion E2. Alternatively, the polishing head assembly 1A may polish the top edge portion E1, the polishing head assembly 1B may polish the bevel portion B, and the polishing head assembly 1C may polish the bottom edge portion E2.

Next, an example of a polishing method in the polishing apparatus 100 having such a configuration will be described below.

As shown in FIG. 1, first, in the load/unload unit 140, the first transfer robot 142 takes out the wafer W before polishing from the wafer cassette placed on the front load portion 141, and transfers the wafer W to the shape measuring device 150. The shape measuring device 150 acquires the profile of the peripheral portion of the wafer W before polishing. The acquired profile of the peripheral portion of the wafer W before polishing is sent from the shape measuring device 150 to the controller 111, and the controller 111 stores the profile of the peripheral portion of the wafer W before polishing. Next, the first transfer robot 142 takes out the wafer W from the shape measuring device 150, and temporarily places the wafer W on the first temporary table 123.

The second transfer robot 122 clamps the wafer W before polishing, which is placed on the first temporary table 123, with hands thereof, and transfers the wafer W to the first polishing module 121a (or the second polishing module 121b). Then, the first polishing module 121a (or the second polishing module 121b) performs polishing process of the peripheral portion of the transferred wafer W under a predetermined polishing conditions (i.e., polishing recipe).

Next, when the polishing process of the wafer W in the first polishing module 121a (or the second polishing module 121b) is completed, the second transfer robot 122 takes out the wafer W after polishing from the first polishing module 121a (or the second polishing module 121b), and temporarily places the wafer W on the second temporary table 124.

When the wafer W after polishing is temporarily placed on the second temporary table 124, the third transfer robot 133 transfers the wafer W after polishing from the second temporary table 124 to the cleaning module 131, and the cleaning module 131 performs the cleaning process to the wafer W. Next, the fourth transfer robot 134 transfers the wafer W after cleaning from the cleaning module 131 to the drying module 132, and the drying module 132 performs the drying process to the wafer W.

Next, the first transfer robot 142 of the load/unload unit 140 takes the wafer W after drying from the drying module 132, and transfers the wafer W to the shape measuring device 150. The shape measuring device 150 acquires the profile of the peripheral portion of the wafer W after polishing. The profile of the peripheral portion of the wafer W after polishing is sent from the shape measuring device 150 to the controller 111, and the controller 111 stores the profile of the peripheral portion of the wafer W after polishing. Thereafter, the first transfer robot 142 takes out the wafer W from the shape measuring device 150, and stores the wafer W in the wafer cassette placed in the front loading portion 141.

As shown in FIG. 1, the controller 111 according to this embodiment incorporates a polishing-information processing apparatus 112 for determining appropriate polishing conditions so as to obtain a desired post-polishing profile of the peripheral portion of the wafer (substrate) W. Although not shown, the controller 111 may be used as the polishing-information processing apparatus, and the polishing-information processing apparatus 112 may be provided separately from the controller 111. In the case where the polishing-information processing apparatus 112 is provided separately from the controller 111, the polishing-information processing apparatus 112 is coupled to the controller 111 so as to be capable of sending and receiving information by wireless or wired communication. Such a polishing-information processing apparatus 112 may be a personal computer, may be a server apparatus, or may be a cloud server constructed in a cloud environment on a network.

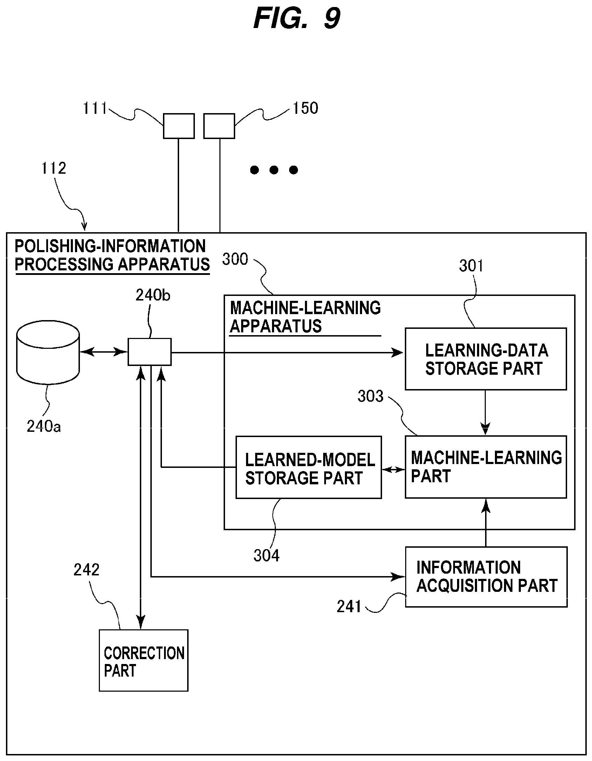

FIG. 9 is a schematic view showing a polishing-information processing apparatus according to one embodiment. The polishing-information processing apparatus 112 shown in FIG. 9 includes a storage device 240a capable of storing programs, data, etc.; a processor (processing device) 240b, such as a CPU (central processing unit) or GPU (graphics processing unit), which performs calculations in accordance with programs stored in the storage device 240a; and an information acquisition part 241 that acquires polishing conditions for polishing the peripheral portion of the wafer W and the profile of the peripheral portion of the wafer W before and after polishing.

The information acquisition part 241 is coupled to the controller 111 and the shape measuring device 150 (see FIG. 1), and acquires, each time the wafer W is polished, the polishing conditions from the controller 111 and the profile of the peripheral portion of the wafer W before and after polishing (i.e., the profile of the peripheral portion of the wafer W before polishing and the profile of the peripheral portion of the wafer W after being polished under the acquired polishing conditions) from the shape measuring device 150. Further, the information acquisition part 241 sends information including a combination of the acquired polishing conditions and the profiles of the peripheral portion of the wafer W before and after polishing to the processor 240b, and the processor 240b stores the received polishing conditions in the storage device 240a in association with the received profiles of the peripheral portion of the wafer W before and after polishing.

Furthermore, the processor 240b sends information (i.e., the combination of the polishing conditions and the profiles of the peripheral portion of the wafer W before and after polishing, which are associated with these polishing conditions) to a learning data storage part 301 of a machine learning apparatus 300, which will be described later, in order to store the information in the learning data storage part 301. The machine learning apparatus 300 is configured to construct, by use of a large amount of information stored in advance in the learning data storage part 301, a learned model for predicting (or outputting) the profile of the peripheral portion of the substrate after polishing when information including at least the polishing conditions and the profile of the peripheral portion of the substrate before polishing, which are newly acquired by the information acquisition part 241, is input.

In this embodiment, the processor 240b of the polishing-information processing apparatus 112 also serves as a prediction apparatus that performs following operations: causing the information acquisition part 241 to acquire information including at least the polishing conditions, the profile of the peripheral portion of the wafer W before polishing, and the profile of the peripheral portion of the substrate after polishing, which has been polished under the polishing conditions; and inputting information including at least the polishing conditions and the profile of the peripheral portion of the substrate before polishing, which are newly acquired by the information acquisition part 241, into the learned model constructed by the machine learning apparatus 300, to thereby predict the profile of the peripheral portion of the wafer W after polishing.

The polishing-information processing apparatus 112 shown in FIG. 9 further includes a correction part 242 for correcting the newly acquired polishing-conditions based on the profile of the peripheral portion of the wafer W after polishing, which is predicted by the learned model, and a target profile of the peripheral portion of the wafer W. The target profile may be stored in advance in storage device 240a, or may be stored in advance in controller 111. In the correction of polishing conditions performed in the correction part 242, known correction method, such as the gradient descent method, may be used. In such correction method, the polishing conditions are corrected based on a difference between the predicted profile of the peripheral portion of the wafer W after polishing and the target profile of the peripheral portion of the wafer W.

The correction part 242 sends the corrected polishing conditions to the processor 240b, and the processor 240b sends the corrected polishing conditions to the controller 111. The controller 111 polishes the peripheral portion of the wafer W with the corrected polishing conditions.

The polishing conditions acquired by the information acquisition part 241, and/or the polishing conditions corrected by the correction part 242 may include, for example, at least one of holding-stage conditions representing a state of the holding stage 4 (see FIG. 4), polishing-head conditions representing a state of the polishing head 30 (see FIG. 5), and polishing-liquid conditions related to the polishing liquid discharged from the polishing liquid supply nozzles 36 and 37 (see FIG. 4).

The holding-stage conditions include at least one of the following: the number of rotation of the holding stage 4 from start of polishing to end of polishing of the wafer W; a rotational speed of the holding stage 4; a rotational acceleration of the holding stage 4; and a rotation time of the holding stage 4 from start of polishing to end of polishing of the wafer W. The rotational acceleration of the holding stage 4 corresponds to an instantaneous change in the rotational speed of the holding stage 4 when the rotational speed of the holding stage 4 changes during a period from the start of polishing to the end of polishing of the wafer W.

The polishing-head conditions include at least one of the following: a pressing force with which the polishing head 30 presses the polishing tape 23 (polishing tool) against the wafer W; a tilt angle range of the polishing head 30 with respect to the peripheral portion of the wafer W when the polishing head 30 moves relative to the peripheral portion of the wafer W by the tilt mechanism; a polishing time during which the polishing head 30 presses the polishing tape 23 against the wafer W; a tilt movement speed at which the polishing head 30 moves relative to the peripheral portion of the wafer W by the tilt mechanism; and a tilt fixing time which is used for temporarily stopping the movement of the polishing head 30 at a predetermined tilt angle.

The polishing-head conditions may include, instead of or in addition to the aforementioned polishing-head conditions, the tension of the polishing tape 23 applied by the polishing-tape supply device and/or a supply speed of the polishing tape 23 fed by the polishing-tape supply device.

The polishing-liquid conditions include at least one of the following: a flow rate of the polishing liquid discharged from the polishing-liquid supply nozzle 36 and/or the polishing-liquid supply nozzle 37; a pressure of the polishing liquid; a temperature of the polishing liquid; a concentration of abrasive grains contained in the polishing liquid when a slurry is used as the polishing liquid; and a position of the polishing-liquid supply nozzle 36 and/or the polishing-liquid supply nozzle 37 with respect to the wafer W.

The profiles of the peripheral portion of the wafer W before and after polishing which are acquired by the information acquisition part 241, and the profile of the peripheral portion of the wafer W after polishing which is predicted by the learned model, include at least one of the following: a center coordinate of a front surface arc portion of the bevel portion; a radius of the front surface arc portion of the bevel portion; a center coordinate of a back surface arc portion of the bevel portion; and a radius of the back surface arc portion of the bevel portion. These values are acquired by the shape measuring device 150.

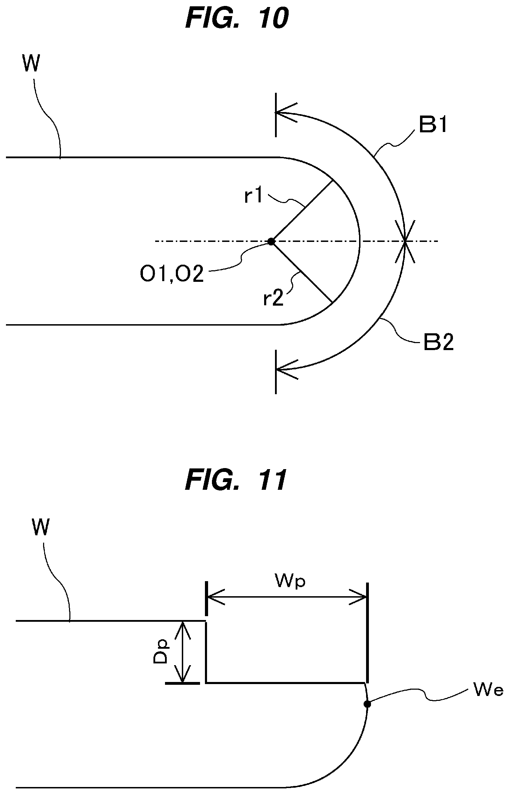

FIG. 10 is a schematic view for illustrating the center coordinate of the front surface arc portion of the bevel portion, the radius of the front surface arc portion, the center coordinate of the back surface arc portion, and the radius of the back surface arc portion of the bevel. In order to determine the center coordinate of the front surface arc portion and the radius of the front surface arc portion in the bevel portion, a polar coordinate system is set with a center O1 of an arc portion B1 on a front surface side of the wafer W as an origin, when viewing the wafer W in a vertical cross-section extending through the center of the wafer W. In this polar coordinate system, the center coordinate of the front surface arc portion corresponds to the origin O1, and the radius of the front surface arc portion corresponds to a distance r1 from the origin O1 to a surface of the arc portion B1 on the front surface side of the wafer W.

Similarly, in order to determine the center coordinate of the rear arc portion and the radius of the rear arc portion in the bevel portion, a polar coordinate system is set with a center O₂ of a rear arc portion B₂ on a rear surface side of the wafer W as origin, when viewing the wafer W in a vertical cross section extending through the center of the wafer W. In this polar coordinate system, the center coordinate of the rear arc portion corresponds to the origin O₂, and the radius of the rear arc portion corresponds to a distance r₂ from the origin O₂ to a surface of the rear arc portion B₂ on the rear surface side of the wafer W. In the example shown in FIG. 10, the origin O₂ coincides with the origin O1, and the distance r2 is the same as the distance r1. However, it is unnecessary for the origin O₂ to coincide with the origin O1, and it is also unnecessary for the distance r2 to be the same as the distance r1.

As shown in FIG. 7, the polishing head 30 of the polishing apparatus according to the present embodiment is capable of polishing the top edge portion of the peripheral portion of the wafer W. In this case, as shown in FIG. 11, the polishing apparatus can polish the top edge portion such that a stepped recess is formed in the peripheral portion of the wafer W. FIG. 11 is a schematic view for illustrating the stepped recess formed in the peripheral portion of the wafer W by the polishing process.

As shown in FIG. 11, in the case where the stepped recess is formed in the peripheral portion of the wafer W, the profiles of the peripheral portion of the wafer W before and after polishing which are acquired by the information acquisition section 241, and the profile of the peripheral portion of the wafer W after polishing which is predicted by the learned model, may include a depth (polishing depth Dp) in the top edge portion which is polished from the front surface of the wafer W, and/or a width (polishing width Wp) of the portion, polished from the outermost edge We of the wafer W, in the top edge portion.

According to this embodiment, the polishing conditions are corrected based on the profile of the peripheral portion of the wafer W after polishing, which is predicted by the learned model, and the target profile of the peripheral portion of the wafer W. As a result, it is possible to automatically and accurately produce appropriate polishing conditions for bringing the profile of the peripheral portion of the wafer W after polishing closer to the target profile.

In one embodiment, a threshold value may be provided for a difference between the predicted profile of the peripheral portion of the wafer W after polishing and the target profile of the peripheral portion of the wafer W. The threshold value is stored in advance in the storage device 240a, or stored in the controller 111. The processor 240b inputs the corrected polishing conditions and the profile of the peripheral portion of the wafer W before polishing into the learned model again, when the difference between the predicted profile of the peripheral portion of the wafer W after polishing and the target profile of the peripheral portion of the wafer W exceeds the threshold value. Then, the profile of the peripheral portion of the wafer W polished under the corrected polishing conditions is sent to the correction part 242, and the correction part 242 re-corrects the corrected polishing conditions based on the profile of the peripheral portion of the wafer W polished under the corrected polishing conditions and the target profile.

When the difference between the profile of the peripheral portion of the wafer W polished under the corrected polishing conditions and the target profile is equal to or less than the threshold value, the processor 240b sends the re-corrected polishing conditions to the controller 111, and the controller 111 polishes the peripheral portion of the wafer W under the re-corrected polishing conditions. When the difference between the profile of the peripheral portion of the wafer W polished under the corrected polishing conditions and the target profile is greater than the threshold value, the processor 240b inputs the re-corrected polishing conditions and the profile of the peripheral portion of the wafer W before polishing into the learned model to predict the profile of the peripheral portion of the wafer W polished under the re-corrected polishing conditions. In this manner, processor 240b may repeat operation of outputting the profile of the peripheral portion of the polished wafer W from the learned model until the difference between the profile of the peripheral portion of the polished wafer W output from the learned model and the target profile is equal to or less than the threshold value.

The machine learning apparatus 300 shown in FIG. 9 serves as an apparatus for constructing a learned model using a learning data set that includes at least information containing a combination of polishing conditions acquired by the information acquisition part 241 and the profiles before and after polishing. As shown in FIG. 9, the machine learning apparatus 300 includes: a learning data storage part 301 for storing the learning data set; a machine learning part 303 for constructing the learned model using the learning data set stored in the learning data storage part 301; and a learned model storage part 304 for storing the learned model constructed by the machine learning part 303.

As described above, the learning data sets stored in the learning data set storage part 301 are a large amount of information containing the combination of the polishing conditions acquired by the information acquisition part 241 each time the peripheral part of the wafer W is polished in the polishing apparatus, and the profiles of the peripheral part of the wafer W before and after polishing. The information containing the combination of the polishing conditions and the profiles of the peripheral portion of the wafer W before and after polishing is accumulated in the learning data set storage part 301 as a learning data set each time the wafer W is polished.

In the machine learning part 303, a machine learning is performed using the learning data set in order to construct the learned model. The machine learning is performed by a learning algorithm, which is an artificial intelligence (AI) algorithm, and the machine learning constructs the learned model that predicts the profile of the peripheral part of the wafer W after polishing. The learning algorithm for constructing the learned model is not particularly limited. For example, a known learning algorithm, such as "supervised learning", "unsupervised learning", "reinforcement learning", "neural network," and the like can be used as the learning algorithm for learning the profile of the peripheral part of the wafer W after polishing.

In one embodiment, the machine learning performed by the machine learning part 303 may be a machine learning using neural network, in particular, deep learning. The deep learning is a neural-network-based learning method, and in that neural network, hidden layers (also referred to middle layers) are multilayered. In the present specification, a machine learning using a neural network constructed of an input layer, two or more hidden layers, and an output layer is referred to as deep learning.

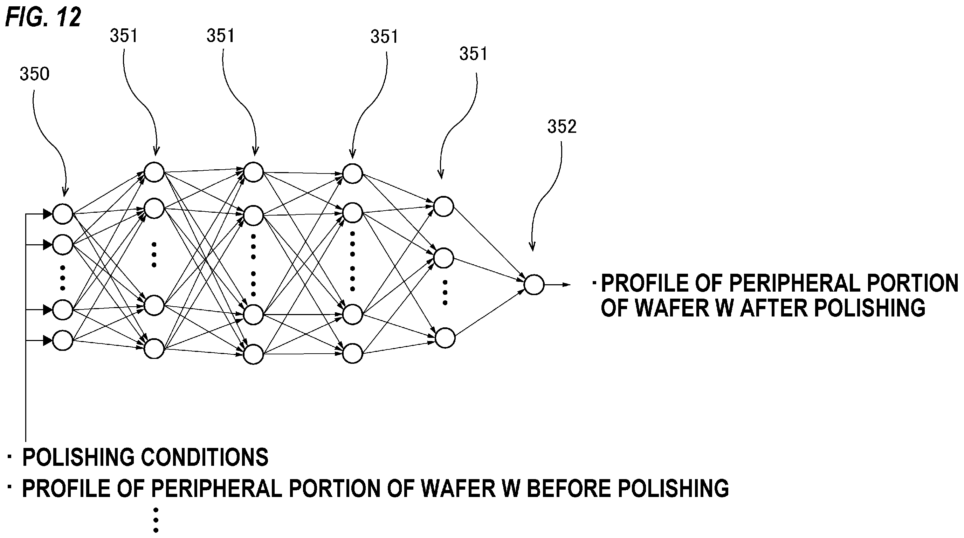

FIG. 12 is a schematic view showing an example of structure of neural network. The neural network shown in FIG. 12 includes an input layer 350, a plurality of hidden layers 351, and an output layer 352. The neural network learns the profile of the peripheral portion of the wafer W after polishing based on the learning data set containing a large number of combinations of the polishing conditions acquired by the information acquisition part 241 and the profiles of the peripheral portion of the wafer W before and after polishing. In other words, the neural network learns a relationship between the polishing conditions and the profile of the peripheral portion of the wafer W before polishing, and the profile of the peripheral portion of the wafer W after polishing. Such machine learning is referred to as "supervised learning." In the supervised learning, a large number of combinations of the polishing conditions and the profile of the peripheral portion of the wafer W before polishing as state variables, and the profile of the peripheral portion of the wafer W after polishing (label) which is associated with those state variables are input to the neural network, and thus the relationship between them is learned inductively.

In the present embodiment, the machine learning part 303 constructs, using the learning data set, the learned model that, when input with the polishing conditions and the profile of the peripheral portion of the wafer W before polishing, outputs the profile of the peripheral portion of the wafer W after being polished with these polishing conditions. The learned model constructed in this manner is stored in the learned model storage part 304.

The learned model stored in the learned model storage part 304 is called up by the processor 240b, which serves as the prediction apparatus, before a new wafer W is polished, and then the processor 240b inputs the polishing conditions for the new wafer W and the profile of the new wafer W before polishing, which are acquired by the information acquisition part 241, into the learned model, to thereby predict the profile of the peripheral portion of the wafer W after polishing. Further, the processor 240b sends the predicted profile of the peripheral portion of the wafer W after polishing and the target profile to the correction part 242, and causes the correction part 242 to correct the polishing conditions for the new wafer W.

The processor 240b may store the polishing conditions for the new wafer W and the profiles of the peripheral portion of the new wafer W before and after polishing as additional learning data in the learning data set storage part 301. In this case, the machine learning apparatus 300 updates the learned model through machine learning based on the learning data and the additional learning data. This operation enables an accuracy of the profile of the peripheral portion of the wafer W after polishing, which is output from the learned model, to be improved.

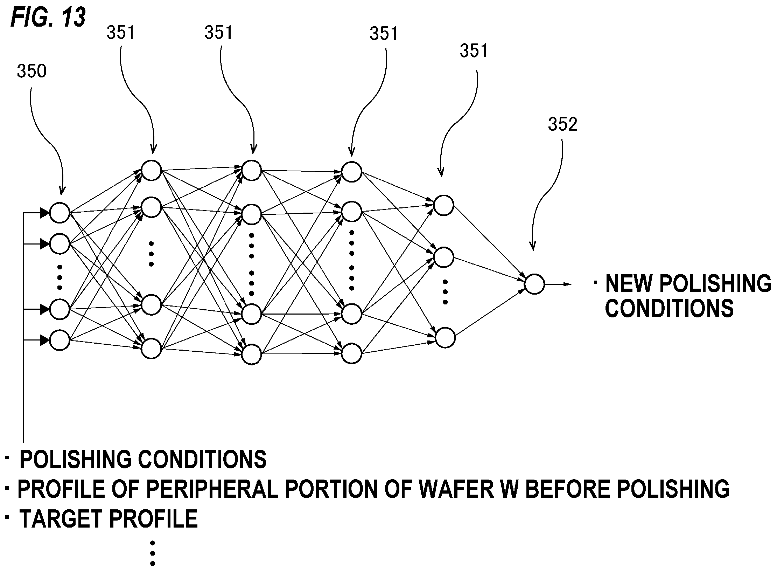

FIG. 13 is a schematic view showing a structure of the neural network according to another embodiment. Configuration of this embodiment, which is not specifically described, is the same as the configuration of the above-described embodiments, and thus duplicate descriptions thereof are omitted.

In the embodiment using the neural network shown in FIG. 13, the machine learning apparatus 300 constructs, using the learning data set, a learned model that predicts (outputs) new polishing conditions for bringing the profile of the peripheral portion of the wafer W after polishing closer to (or to match with) the target profile when the polishing conditions, the profile before polishing, and the target profile as state variables are input to the input layer 350. The learning data set includes, in the same manner as the embodiment described above, at least the information containing the combination of the polishing conditions and the profiles of the periphery of the wafer W before and after polishing.

In the present embodiment, the processor 240b of the polishing-information processing apparatus 112, which also serves as the prediction apparatus, causes the information acquisition section 241 to acquire information including at least the polishing conditions, the profile of the peripheral portion of the wafer W before polishing, and the target profile; and causes the learned model constructed by the machine learning apparatus 300 to input information including at least the polishing conditions newly acquired by the information acquisition part 241, the profile of the peripheral portion of the wafer W before polishing, and the target profile, to predict new polishing conditions for bringing the profile of the peripheral portion of the wafer W after polishing closer to the target profile.

In the present embodiment, the correction part 242 of the polishing-information processing apparatus 112 shown in FIG. 9 is omitted. The processor 240b, which also serves as a prediction apparatus, sends the new polishing conditions predicted to the controller 111, and the controller 111 polishes the peripheral portion of the wafer W under the new polishing conditions.

In the present embodiment, the learned model predicts the new polishing conditions for bringing the profile of the peripheral portion of the wafer W after polishing closer to the target profile, and the peripheral portion of the wafer W is polished under the new polishing conditions. Specifically, it is possible to automatically and accurately produce appropriate polishing conditions for bringing the profile of the peripheral portion of the wafer W after polishing closer to the target profile.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a polishing-information processing apparatus provided in a polishing apparatus for polishing a substrate, such as a wafer, and in particular to a polishing-information processing apparatus provided in a polishing apparatus for polishing a peripheral portion of a substrate. Further, the present invention is applicable to a prediction apparatus for predicting a profile of a peripheral portion of a substrate after polishing, and a prediction apparatus for predicting polishing conditions used in a polishing apparatus. Furthermore, the present invention is applicable to a machine learning apparatus for constructing a learned model for predicting a profile of a peripheral portion of a substrate after polishing, and a machine learning apparatus for constructing a learned model for predicting polishing conditions used in a polishing apparatus.

### Reference Signs List

- 1A-1D: polishing head assemblies (polishing portion)
- 2A-2D: polishing-tape supply mechanism
- 3: rotary holding mechanism (substrate holder)
- 4: holding stage
- 5: hollow shaft
- 6: ball spline bearing
- 7: communication line
- 9: vacuum line
- 10: nitrogen-gas supply line
- 15: air cylinder
- 20: partition
- 24: supply reel
- 25: recovery reel
- 30: polishing head
- 41: pressing mechanism
- 42: tape feed mechanism
- 43-49: guide roller
- 50: pressing pad
- 52: air cylinder (actuator)
- 67: linear actuator
- 100: polishing apparatus
- 111: controller
- 112: polishing-information processing apparatus
- 120: polishing unit
- 121a, 121b: polishing module
- 122: second transfer robot
- 128: transfer area
- 130: cleaning unit
- 131: cleaning module
- 132: drying module
- 133: third transfer robot
- 134: fourth transfer robot
- 140: load/unload unit
- 141: front loading portion
- 142: first transfer robot
- 150: shape measuring device
- 240a: storage device
- 240b: processor (processing device)
- 241: information acquisition part
- 242: correction part
- 300: machine learning apparatus
- 301: learning data storage part
- 303: machine learning part
- 304: learned model storage part

## Claims

1. A polishing-information processing apparatus for a polishing apparatus which polishes a peripheral portion of a substrate by pressing a polishing tool against the peripheral portion of the substrate with a polishing head in a presence of a polishing liquid while rotating the substrate held on a holding stage, comprising:
an information acquisition part configured to acquire polishing conditions for polishing the peripheral portion of the substrate, a profile of the peripheral portion of the substrate before polishing, and a profile of the peripheral portion of the substrate after polishing under the polishing conditions;
a state prediction part configured to predict the profile of the peripheral portion of the substrate after polishing by inputting information including at least the polishing conditions and the profile of the peripheral portion of the substrate before polishing, which are newly acquired by the information acquisition part, into a learned model constructed using a learning data set which includes at least a combination of the polishing conditions and the profiles before and after polishing acquired in advance by the information acquisition part; and
a correction part configured to correct the newly acquired polishing conditions based on the profile of the peripheral portion of the substrate after polishing predicted by the state prediction part and the target profile of the peripheral portion of the substrate.

2. The polishing-information processing apparatus according to claim 1, wherein the polishing conditions include holding-stage conditions representing a state of the holding stage; and
the holding-stage conditions include at least one of the number of rotations of the holding stage from start of polishing to end of polishing of the substrate, a rotational speed of the holding stage, a rotational acceleration of the holding stage, and a rotation time of the holding stage from start of polishing to end of polishing of the substrate.

3. The polishing-information processing apparatus according to claim 1, wherein the polishing apparatus further comprises a tilt mechanism capable of tilting the polishing head with respect to the peripheral portion of the substrate;
the polishing conditions include polishing-head conditions representing a state of the polishing head; and
the polishing-head conditions include at least one of a pressing force with which the polishing head presses the polishing tool against the substrate, a tilt angle range of the polishing head with respect to the peripheral portion of the substrate, a polishing time during which the polishing head presses the polishing tool against the substrate, a tilt movement speed at which the polishing head moves relative to the peripheral portion of the substrate, and a tilt fixing time which is used for temporarily stopping the movement of the polishing head at a predetermined tilt angle.

4. The polishing-information processing apparatus according to claim 3, wherein the polishing tool comprises a polishing tape;
the polishing apparatus further comprises a polishing-tape supply device configured to supply the polishing tape to the polishing head while applying tension to the polishing tape; and
the polishing-head conditions further include the tension of the polishing tape and/or a supply speed of the polishing tape.

5. The polishing-information processing apparatus according to claim 1, wherein the polishing apparatus further comprises a polishing-liquid supply nozzle configured to supply the polishing liquid onto the substrate;
the polishing conditions include polishing-liquid conditions related to the polishing liquid; and
the polishing liquid conditions include at least one of a flow rate of the polishing liquid discharged from the polishing-liquid supply nozzle, a pressure of the polishing liquid, a temperature of the polishing liquid, a concentration of abrasive grains contained in the polishing liquid, and a position of the polishing-liquid supply nozzle with respect to the substrate.

6. The polishing-information processing apparatus according to claim 1, wherein the peripheral portion of the substrate includes a bevel portion that is the outermost surface of the substrate, and
the profile of the peripheral portion of the substrate before polishing included in the learning data set, and the profile of the peripheral portion of the substrate after polishing predicted by the learned model include at least one of:
a center coordinate of a front surface arc portion of the bevel portion;
a radius of a front surface arc portion of the bevel portion;
a center coordinate of a back surface arc portion of the bevel portion; and
a radius of a back surface arc portion of the bevel portion.

7. The polishing-information processing apparatus according to claim 1, wherein the peripheral portion of the substrate includes a bevel portion which is the outermost surface of the substrate, and a top edge portion which is a flat portion located radially inwardly of the bevel portion, and
the profile of the peripheral portion of the substrate after polishing included in the learning data set, and the profile of the peripheral portion of the substrate after polishing predicted by the learned model include a polishing width of the top edge portion and/or a polishing depth of the top edge portion.

8. A prediction apparatus for predicting a profile of a peripheral portion of a substrate polished by a polishing apparatus configured to polish the peripheral portion of the substrate by pressing a polishing tool against the peripheral portion of the substrate with a polishing head in a presence of a polishing liquid while rotating the substrate held on a holding stage, comprising a processor configured to perform:
an information acquisition process for acquiring information including at least polishing conditions for polishing the peripheral portion of the substrate, a profile of the peripheral portion of the substrate before polishing, and a profile of the peripheral portion of the substrate after polishing under the polishing conditions; and
a prediction process of inputting polishing conditions and a profile of the peripheral portion of the substrate before polishing which are newly acquired by the information acquisition process, into a learned model which is constructed using a learning data set including information acquired in advance by the information acquisition process, to thereby predict a profile of the peripheral portion of the substrate after polishing.

9. A machine learning apparatus for constructing a learned model that outputs a profile of a peripheral portion of a substrate after a polishing process in which a polishing tool is pressed against the peripheral portion of the substrate with a polishing head in a presence of a polishing liquid while rotating the substrate held on a holding stage, comprising:
a learning data storage part configured to store a learning data set constructed by a plurality of pieces of information containing a combination of polishing conditions for polishing the peripheral portion of the substrate, a profile of the peripheral portion of the substrate before polishing, and a profile of the peripheral portion of the substrate after polishing under the polishing conditions;
a machine learning part configured to construct the learned model for predicting the profile of the peripheral portion of the substrate after polishing by inputting the learning data set into the learning model; and
a learned model storage part configured to store the learned model constructed by the machine learning part.

10. A polishing-information processing apparatus for a polishing apparatus which polishes a peripheral portion of a substrate by pressing a polishing tool against the peripheral portion of the substrate with a polishing head in a presence of a polishing liquid while rotating the substrate held on a holding stage, comprising:
an information acquisition part configured to acquire polishing conditions for polishing the peripheral portion of the substrate, a profile of the peripheral portion of the substrate before polishing, and a profile of the peripheral portion of the substrate after polishing under the polishing conditions; and
a state prediction part configured to predict new polishing conditions for bringing the profile of the peripheral portion of the substrate after polishing closer to the target profile by inputting information including at least the polishing conditions and the profile of the peripheral portion of the substrate before polishing, which are newly acquired by the information acquisition part, and a target profile, into a learned model constructed using a learning data set which includes at least a combination of the polishing conditions and the profiles before and after polishing acquired in advance by the information acquisition part.

11. A prediction apparatus for predicting polishing conditions used in a polishing apparatus configured to polish the peripheral portion of the substrate by pressing a polishing tool against the peripheral portion of the substrate with a polishing head in a presence of a polishing liquid while rotating the substrate held on a holding stage, comprising a processor configured to perform:
an information acquisition process for acquiring information including at least polishing conditions for polishing the peripheral portion of the substrate, a profile of the peripheral portion of the substrate before polishing, and a profile of the peripheral portion of the substrate after polishing under the polishing conditions; and
a prediction process of inputting polishing conditions, a profile of the peripheral portion of the substrate before polishing, and a target profile which are newly acquired by the information acquisition process, into a learned model which is constructed using a learning data set including information acquired in advance by the information acquisition process, to thereby predict new polishing conditions for bringing the profile of the peripheral portion of the substrate after polishing closer to the target profile.

12. A machine learning apparatus for constructing a learned model that outputs polishing conditions for polishing process in which a polishing tool is pressed against a peripheral portion of a substrate with a polishing head in a presence of a polishing liquid while rotating the substrate held on a holding stage, comprising:
a learning data storage part configured to store a learning data set constructed by a plurality of pieces of information containing a combination of polishing conditions for polishing the peripheral portion of the substrate, a profile of the peripheral portion of the substrate before polishing, and a profile of the peripheral portion of the substrate after polishing under the polishing conditions;
a machine learning part configured to construct a learned model for outputting new polishing conditions for bringing the profile of the peripheral portion of the substrate after polishing closer to the target profile by inputting the learning data set into the learning model; and
a learning model storage part configured to store the learned model constructed by the machine learning part.
